# EUROPEAN PATENT APPLICATION

(11) **EP 1 152 471 A2**
(43) Date of publication of application: **07.11.2001**
(21) Application number: 01201359.5
(22) Date of filing: 13.04.2001
(51) Int. Cl.: H01L 31/02, H01L 27/146

(54) **Image sensor pixel for configurable output**

(30) Priority: 28.04.2000 US 561431
(71) Applicant: EASTMAN KODAK COMPANY, Rochester, New York 14650 (US)
(72) Inventor: Lee, Paul Poo-Kam, c/o Eastman Kodak Company, Rochester, New York 14650-2201 (US)
(74) Representative: Lewandowsky, Klaus, Dipl.-Ing.

(57) **Abstract**

A pixel design for CMOS image sensors that has a high frame rate potential and motion capture capabilities. The pixel architecture provides for a CMOS based, active pixel image sensor comprising an array of pixels formed in rows and columns, with each of the pixels containing at least one active circuit element. There are a plurality of output channels formed such that each of the output channels are operatively connected to a subset of pixels wherein each of the pixel have an attribute that is the same. The pixel architecture also provides an output gate region and a shutter gate region that are symmetric about the center of the pixel. By arranging the shutter and transfer gates, a symmetric manner about the center of the pixel, a more efficient transfer of electrons to these gates is provided.

## Description

The present invention relates to the field of solid-state image sensing devices and, more specifically, to CMOS based active pixel sensors.

There are numerous prior art disclosures for Charge Coupled Device (CCD) technology that teach the usefulness of building multiple and parallel output channels for image sensors. Prior art image sensor references such as A Solid -State Image Sensor for Image Recording at 2000 Frames Per Second, by T-H. Lee, T. J. Tredwell, B. C. Burkey, C. Anagnostopoulos, J. S. Hayward, T. M. Kelly, R. P. Khosla, D. L. Losee, and J. P. Lavine in IEEE Transactions on Electronic Devices, Vol. ED-19, No. 9, pp. 1469-1477, Sept. 1982, teach high speed sensors employing multiple parallel output channels. These prior art image sensors have pixels typically arranged according to their location within the sensor and , accordingly, these devices have a short coming in that they do not use specific pixel attributes (such as color or sensitivity) to organize the channels. In the organization of high speed sensors, it is desirable to dedicate a single channel to a specific attribute, such as color or sensitivity, since the sensitivity of the pixel is dependent upon these attributes.

CMOS active pixel image sensors have been rapidly developed to supplement and replace charge-coupled devices in many applications. CMOS image sensors have advantages in low-power operation as well as the higher integration capabilities for on-chip signal processing and control functions that are available with CMOS technology. Therefore, the technology is suitable for many consumer applications, including low-cost portable imaging devices. However, in the application areas of industrial cameras and high-frame rate recording, CMOS sensors have been handicapped by output channels which are based on partitioning of contiguous pixels.

From the foregoing discussion, it should be readily apparent that there remains a need within the art for a sensor design that provides parallel outputs channels that are specific to pixel attributes rather than pixel location.

The present invention addresses the shortcomings within the prior art by providing a pixel design for CMOS image sensors that has a high frame rate potential and, therefore, provides motion capture capabilities. The pixel architecture provides for a CMOS based, active pixel image sensor comprising an array of pixels formed in rows and columns, with each of the pixels containing at least one active circuit element. There are a plurality of output channels formed such that each of the output channels are operatively connected to a subset of pixels wherein each of the pixel have an attribute that is the same.

The pixel architecture also provides an output gate region and a shutter gate region that are symmetric about the center of the pixel. By arranging the shutter and transfer gates, a symmetric manner about the center of the pixel, a more efficient transfer of electrons to these gates is provided. A Pixel Output Bus structure allows configurable connections to column-wise signal busses that provide parallel output channels. The pixel is designed for global electronic shuttering so every pixel is exposed simultaneously to images incident upon the pixel array plane. This present invention is intended for use in a high frame rate image sensor that is fabricated using a Complementary Metal Oxide Semiconductor (CMOS) active pixel sensor (APS) technology and preferably incorporating a pinned photo-diode.

The present invention has the advantages of: (1) Allowing the accommodation of changes in the pixel output groupings for different monochrome output format or CFA patterns with only changes in metal routing layers; (2) allowing true electronic shuttering to image moving scene with all the pixels having the same capture time windows; and (3) providing a symmetric global shutter gate and transfer gate to minimize pixel related fixed pattern noise.
Fig. 1 is a segment of the Bayer CFA pattern design showing the 4-pixel unit kernel;
Fig. 2a is a block diagram representation of the parallel output channels connected to a CFA kernel of 4 pixels similar to the Bayer pattern shown in Fig. 1;
Fig. 2b is an alternative CFA pattern where the kernel is stripes of the color occupying an entire row. The number of column busses required is increased to 4. To change to a Bayer pattern, only 2 of these column busses are used;
Fig. 2c is a similar four column-bus arrangement as shown in Figure 2b "reconfigured" to allow this 4 x 4 color mosaic pattern to be wired for color-specific output channels. An example of such a 4 x 4 pattern is given in U.S. Patent No. 5,631,703 by Hamilton et al.;
Fig. 2d is a similar four column-bus arrangement as shown in Figs. 2b and 2c above that is "reconfigured" for a mosaic pattern based on a pixel pattern having different sensitivities with sensitivity specific output channels;
Fig. 3a block diagram of the high frame rate pixel design showing the symmetry of the transfer gate and the shutter gate as well as the Pixel Output Bus and its configurable connection to the output bus;
Fig. 3b is a schematic view of a cross-sectional area of the pixel shown in Fig. 3a through the shutter gate, center of the pixel, and the transfer gate showing the electrostatic potential;
Fig. 3c is a cross section for a prior art device illustrating a non-symmetrical arrangement of the transfer gate and the shutter gate with a corresponding uneven potential path from the center of photodiode to these gates.

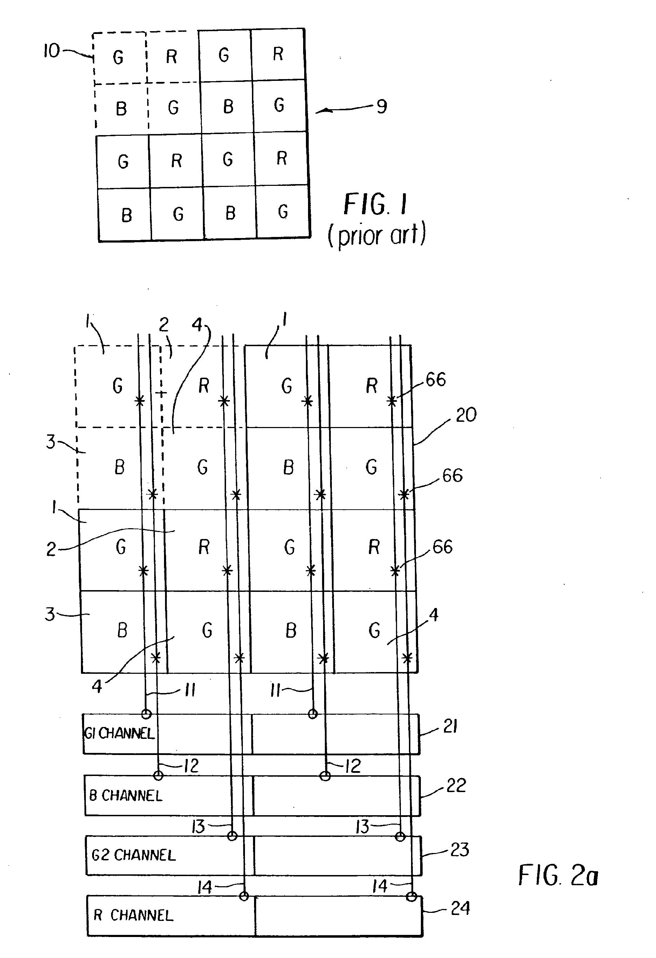

Fig. 1 is a prior art example of a unit kernel 10 known as the Bayer CFA pattern design showing the four-pixel unit kernel 10 wherein G=green, R=red, and B=blue illustrates the color sensitivity of the individual pixels. The 2 x 2 pattern illustrated in the unit kernel 10 is a conventional prior-art image sensor transistors. Finally, layers of isolation dielectric are overlaid between the semiconductor active devices and metal wiring layers which are patterned to connect the devices to form circuits to carry out specific electronic functions. In image sensor fabrication, additional layers such as Color Filter Array (CFA) and micro-lens are also used. The CFA layer consists of mosaic of a CFA kernel repeated over the imaging pixel array. Each kernel contains patterned pixel areas with specific color so each of the photo-sensing element underneath sees only light rays of one specific color only.

In a high frame rate image sensor where effective pixel output rates reach into the 100's of millions of pixels per second, multiple parallel channels are employed. A reference that discusses such sensors is A Solid -State Image Sensor for Image Recording at 2000 Frames Per Second, by T-H. Lee, T. J. Tredwell, B. C. Burkey, C. Anagnostopoulos, J. S. Hayward, T. M. Kelly, R. P. Khosla, D. L. Losee, and J. P. Lavine in IEEE Transactions on Electronic Devices, Vol. ED-19, No. 9, pp.1469-1477, Sept. 1982. This prior art reference (as well as others) teaches multiple parallel channels arranged according to location within the sensor. However, it does not teach using specific pixel attributes to organize the channels. In the organization of high speed sensors, it is desirable to dedicate a single channel to a specific attribute, such as color or sensitivity, since the sensitivity of the pixel is dependent upon these attributes. The channel electronics can then be optimized for the specific attribute, for example the electronic gain is set to an optimal level. Therefore, all pixels of the same attribute are connected to one output channel using a dedicated connection matrix and the pixels having that attribute are hard-wired to the output channel of choice. That output channel then has electronics specific to the attribute being output on that output channel.

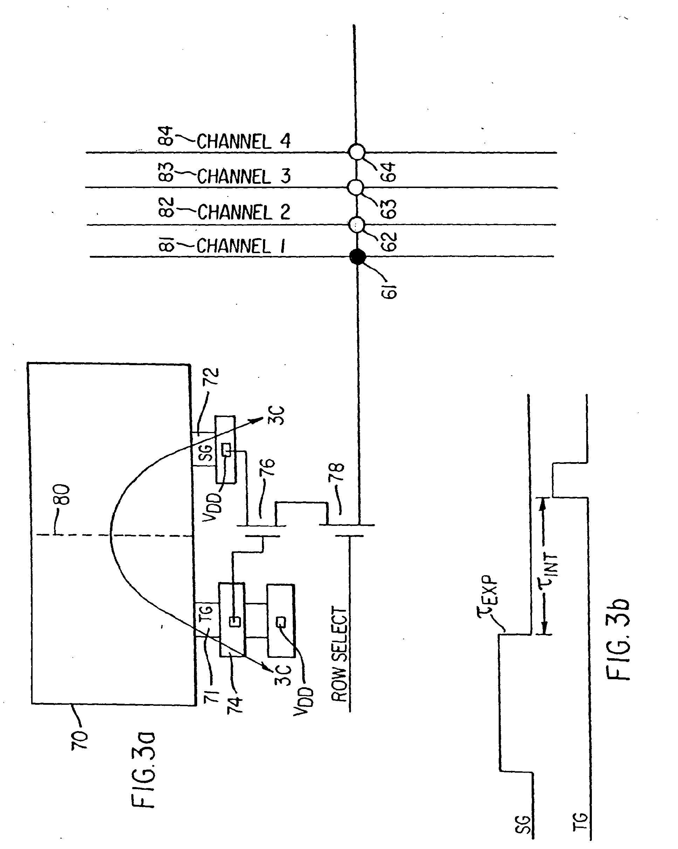

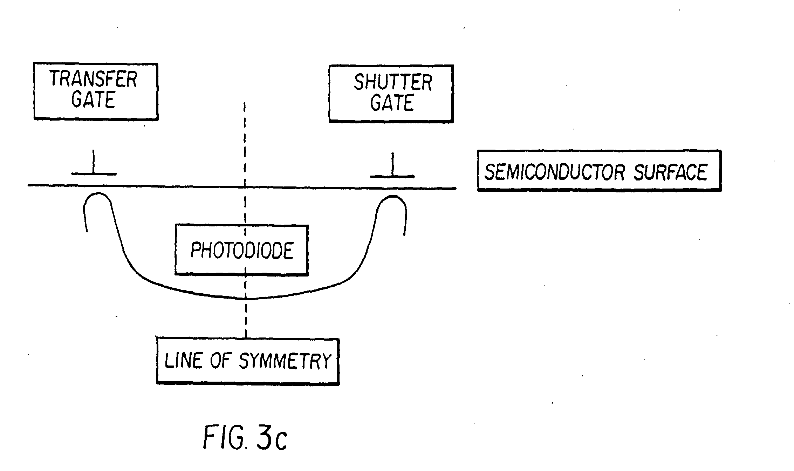

In the present invention, the pixel has an output bus region which allows the determination of the final connections by changes in the metal/via/contact layers only. Therefore, the output channel assignments can be modified for different CFA patterns with minimal costs associated with metal/via/contact masking steps in the manufacturing process. This is illustrated in Figs. 2a-d and 3a-c for a four-channel implementation with either a two or a four output column bus.

Fig. 2a is a block diagram representation of the present invention wherein image sensor 20 has parallel output channels 21, 22, 23, 24 being connected to a CFA. The CFA has a kernel of four pixels such as the Bayer pattern connection matrix of Fig. 1. The image sensor 20 illustrated in Fig. 2a has a basic difference to the prior art image sensor 9 shown in Fig. 1, in that each of the four pixels 1, 2, 3, 4 in the kernel is connected to one of the separate output channels 21, 22, 23, 24 such that all pixels 1 are connected to conductive traces 11 connecting pixels 1 with the output channel 21. Pixels 2, 3 and 4 are connected in a similar manner to output channels 22, 23, 24 through conductive traces 12, 13, and 14. Conductive traces 11, 12, 13, 14 connect to each of the pixels 1, 2, 3, 4 through vias 66. This connection through the vias 66 is envisioned as being one that can be hardwired when the image sensor 20 is originally manufactured, or made to be configurable in a variety of ways.

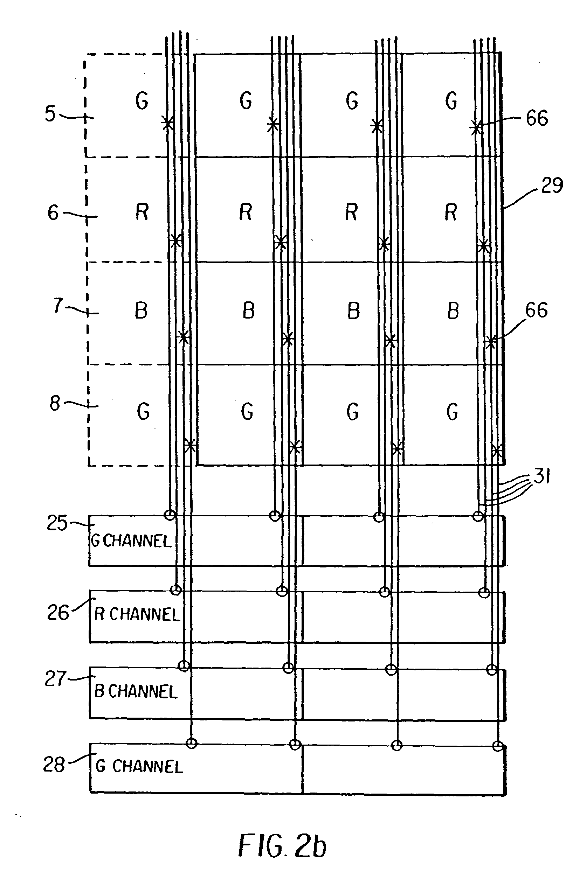

Fig. 2b is an alternative CFA pattern where the kernel is formed as stripes of the color occupying entire rows 5, 6, 7, 8. The number of column busses required is increased to four. To change to a Bayer pattern, like that of the sensor shown in Fig. 2a, the vias 66 would be created to connect only two of these column busses leaving the remaining column busses unused. Image sensor 29 has parallel output channels 25, 26, 27, 28 being connected to a CFA of image sensor 29. The CFA has a kernel of four pixels arranged in rows 5, 6, 7, 8 such that each of the rows 5, 6, 7, 8 of pixels in the kernel is connected to one of the separate output channels 25, 26, 27, 28. Each of the pixels within the rows 5 6, 7, 8 are connected to conductive traces 31 that connect the pixels with the output channels 24, 25, 26, 27 through vias 66. This connection through the vias 66 is envisioned as being one that can be hardwired when the image sensor 29 is originally manufactured, or made to be configurable in a variety of ways.

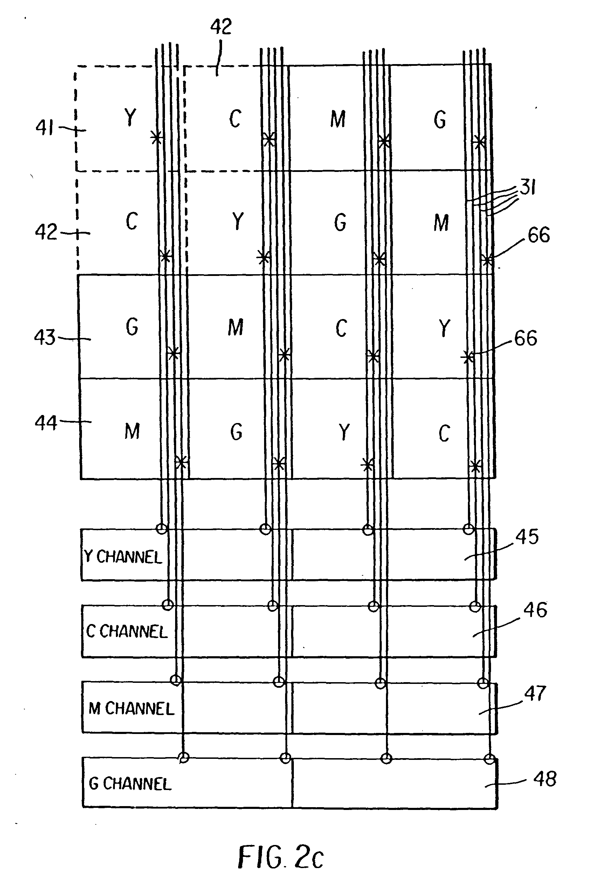

Fig. 2c illustrates that the same four column-bus arrangement shown in Fig. 2b can be "reconfigured" using minimal interconnect masking changes to allow this 4 x 4 color mosaic pattern to be wired for color-specific output channels. The pattern shown in Fig. 2c is a complementary color pattern having yellow color filters Y, cyan color filters C, magenta color filters M, and green color filters G. Each of the pixels within the pixels 41, 42, 43, 44 are connected to conductive traces 31 to output channels 45, 46, 47, 48 through vias 66.

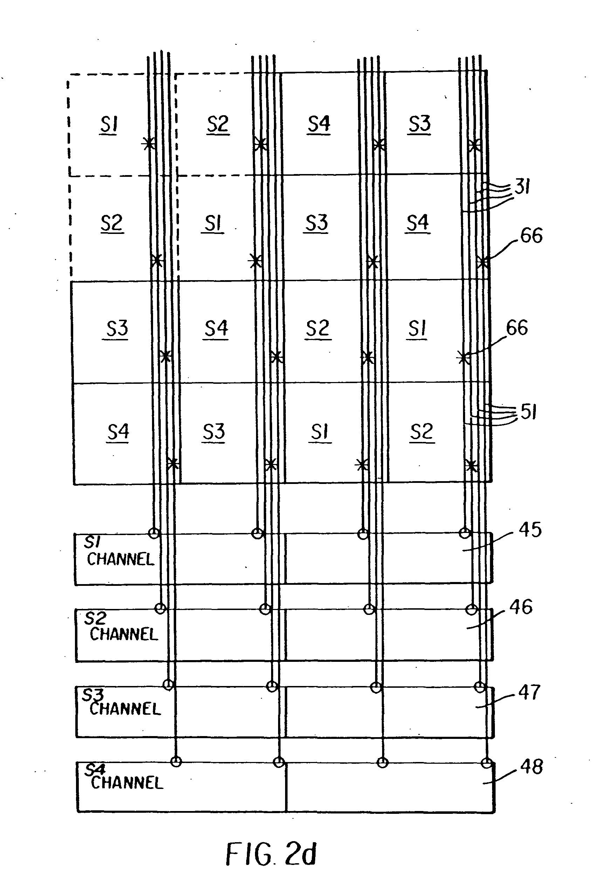

Fig. 2d is a similar four column-bus arrangement as shown in Figs. 2b and 2c above that is "reconfigured" for a mosaic pattern based on pixel sensitivities and with sensitivity specific output channels. As seen in Fig. 2d there are four pixel sensitivities S1, S2, S3, S4 connected, respectively, to conductive traces 51 through vias 66 to output channels 45, 46, 47, 48.

In high frame rate imaging, it is also desirable to have all the pixels be exposed to a scene simultaneously with the timing controlled electronically. In a Charge-Coupled Device (CCD) image sensor, this is typically accomplished by using a vertical over-flow drain (VOD). In CMOS APS, this would add complex processing steps and therefore add cost. The present invention discloses the use of an additional reset transistor in the pixel design to allow reset of the photo-diode sensing node independently of the transfer gate and reset gate of the floating diffusion sensing node. The design of this electronic shutter gate is such that the layout of the photo-diode is symmetric with respect to the two transistors gate performing either a transfer of the collected photo-carriers into a sensing node (the transfer gate) or a reset node (electronic shutter gate). Using this dual gated photo-diode and by connecting them for all the pixels in the array globally, the timed exposure of the pixels are determined by the time interval between the global reset of the photo-diodes and the global transfer of the photo charges to the sensing node. This design is illustrated in Figs. 3a-c.

Fig. 3a is a block diagram of the high frame rate pixel design wherein a line of symmetry 80 can be drawn that, essentially, divides the pixel into two equal halves. A transfer gate 71 and a shutter gate 72 are formed within the pixel such that the location of the transfer gate 71 is an equal distance from the center of the pixel as the shutter gate 72. The placement of the shutter gate 72 and the transfer gate 71 are not only equidistant from the center of the pixel butare symmetrically placed about the line of symmetry 80. This provides for superior drainage of the electrons from the pixel which is useful in high speed devices, such as the multiple channel device of the present invention. The layout of the shutter gate 72 and the transfer gate 71 about the line of symmetry 80 within pixel 70 does not have to be as shown in Fig, 3a. Any pixel design that can place a shutter gate and a transfer gate such that they are equal distances from the center can essentially have a line of symmetry drawn between the shutter and transfer gates. This is very apparent with pixel design having photodetectors that are shaped in square, rectangular, circular and oval configurations. The Pixel Output Bus within the preferred embodiment would typically have a select transistor which connects to either one of the four column bus for channels 1, 2, 3 or 4 (81, 82, 83, 84) with only backend metal via mask layer changes by selectively making contact between the pixel output bus to one of the four column bus using one of the contacts/vias 61, 62, 63 or 64. By changing these masks which are late in the processing sequence, the sensor can is configurable for different CFA patterns.

Fig. 3b shows the timing for the shuttering and integration periods of the pixel 70 seen in Fig. 3a. The shutter gate 72 will be active prior the time τ_{Exp} in order to reset pixel 70 to a predetermined potential, which in the case of the preferred embodiment is VDD. This effectively is the shutter operation to the pixel 70. At time τ_{Exp}, the signal SG to the shutter gate 72 go inactive and the integration period τ_{INT} begins. Once the integration period for the pixel is complete, the transfer gate signal TG pulses transferring the photoelectrons from the pixel onto the floating diffusion 74. The floating diffusion 74 acts as an input to the gate of source follower transistor 76 which provides amplification that is enabled by row select transistor 78.

The present invention has advantages in: (1) accommodate changes in pixel output groupings for different monochrome output format or CFA patterns with only changes in metal routing layers; (2) allowing true electronic shuttering to image moving scene with all the pixels having the same capture time windows; and(3) providing symmetric global shutter gate and transfer gate to minimize pixel related fixed pattern noise.

## Claims

1. An active pixel image sensor comprising:
an array of pixels formed in rows and columns, with each of the pixels containing at least one active circuit element;
a plurality of output channels, each of the output channels being operatively connected to a subset of pixels for at least one of the columns; and
an output structure to provide a buffered output for each of the channels.

2. The image sensor of claim 1 wherein each of the subsets have pixels of one sensitivity.

3. The image sensor of claim 1 wherein each of the subsets further comprise the pixels being sensitive to one color.

4. The image sensor of claim 1 wherein each of the subsets have pixels the same integration time.

5. The image sensor of claim 4 further comprising at least two subsets having different integration times.

6. The image sensor of claim 1 wherein the output rate of the sensor is directly proportional to the number of channels.

7. The image sensor of claim 1 wherein the output structure further comprises means for combining the channels in a predetermined manner.

8. The image sensor of claim 1 wherein the output channels are connected to the subsets through conductive layers.

9. The image sensor of claim 8 wherein the conductive layers allow for alternative pixel-to-channel configurations.

10. The image sensor of claim 8 wherein the conductive layers accommodate reconfigurable arrangement to support specific color per channel.
